# FASCICULE DE BREVET EUROPEEN

(11) **EP 3 241 411 B1**
(45) Date de publication et mention de la délivrance du brevet: **15.08.2018**
(21) Numéro de dépôt: 15798383.4
(22) Date de dépôt: 18.11.2015
(51) Int. Cl.: H05K 1/02

(54) **BOITIER HYPERFREQUENCE A ENCOMBREMENT REDUIT EN SURFACE ET MONTAGE D'UN TEL BOITIER SUR UN CIRCUIT**
HYPERFREQUENTES GEHÄUSE MIT KLEINER OBERFLÄCHENBELEGUNG UND MONTAGE SOLCH EINES GEHÄUSES AUF EINER SCHALTUNG
HYPERFREQUENCY HOUSING OCCUPYING A SMALL SURFACE AREA AND MOUNTING OF SUCH A HOUSING ON A CIRCUIT

(30) Priorité: 30.12.2014 FR 1403029
(43) Date de publication de la demande: 08.11.2017
(73) Titulaire: Thales, 92400 Courbevoie (FR)
(72) Inventeur: GREMILLET, Patrick, F-78851 Elancourt (FR); LEDAIN, Bernard, F-78851 Elancourt (FR)
(74) Mandataire: Lucas, Laurent Jacques
(86) Numéro de dépôt international: PCT/EP2015/076895
(87) Numéro de publication internationale: WO 2016/107692

(56) Documents cités:
- EP-A2- 0 872 888
- EP-A2- 1 657 749
- FR-A1- 2 849 346

## Description

La présente invention concerne un boîtier hyperfréquence à encombrement réduit en surface. Elle concerne également un montage d'un tel boîtier sur un circuit de type multicouche.
Elle s'applique notamment dans le domaine de l'encapsulation des composants hyperfréquence montés en surface sur des circuits multicouches. Ces composants hyperfréquence sont par exemple utilisés dans des applications radars, avioniques, spatiales ou de télécommunication.

L'encapsulation des composants ou fonctions hyperfréquence a plusieurs objectifs vis-à-vis de l'environnement externe. En particulier, elle assure une protection physique, une protection électromagnétique et permet l'interconnexion électrique avec l'extérieur, notamment pour les relier électriquement à d'autres composants, à des signaux de commande et des sources d'alimentation, via des circuits imprimés.
Un certain nombre de techniques d'encapsulation permettent de remplir de façon plus ou moins performante ces objectifs.
L'une d'entre elles est connue sous le nom de «Ball Grid Array », généralement dite technique BGA. Cette technique consiste en un boîtier dont l'interconnexion vers le circuit imprimé est assurée par des billes métalliques placées dans un plan parallèle à la surface des composants. Une solution adaptée aux composants hyperfréquence, avec un boîtier assurant une bonne protection électromagnétique vis-à-vis de l'environnement extérieur, est décrite dans le document FR 2 849 346.
Un inconvénient de cette solution est que le boîtier possède une surface importante, puisqu'il doit comprendre les composants mais aussi leur interconnexion intermédiaire et les parois du boîtier.
Or, il existe des applications qui imposent de sévères contraintes d'encombrement, comme par exemple les modules d'émission et de réception de type actif où la maille est liée à la longueur d'onde des signaux émis. Dans ces cas où la surface disponible pour recevoir les composants encapsulés est contrainte, la solution ci-dessus est difficile à utiliser. Une solution connue pour surmonter ce problème de contrainte est d'utiliser des boîtiers à plusieurs étages, réduisant ainsi la surface occupée sur le circuit imprimé. Une telle solution est notamment décrite dans le document FR 2 877 537. Un inconvénient de cette solution réside dans le fait qu'elle complique l'interconnexion interne du boîtier.

Un but de l'invention est notamment de pallier les inconvénients précités, et de permettre la réalisation de boîtiers hyperfréquence à encombrement réduit en surface. A cet effet, l'invention a pour objet un boîtier, apte à encapsuler au moins un composant hyperfréquence, formant une cavité fermée de type cage de Faraday ayant des parois latérales reposant sur une base surmontées d'un capot, au moins une desdites parois latérales comportant des éléments de connexions électriques extérieurs reliées électriquement à l'intérieur de ladite cavité, lesdits éléments de connexions extérieures étant aptes à s'interconnecter avec un circuit extérieur de sorte que ladite paroi latérale soit face audit circuit extérieur lorsque lesdits éléments de connexions extérieures sont interconnectées avec ledit circuit.

Dans un mode de réalisation particulier, lesdites connexions extérieures sont des billes conductrices.

Ladite paroi latérale est par exemple composée d'un matériau isolant recouvert côté extérieur d'une couche comprenant plusieurs surfaces conductrices isolées électriquement les unes des autres et recouvert côté intérieur d'une surface conductrice unique, lesdits éléments de connexions extérieures étant fixées sur lesdites surfaces conductrices.

Lesdits éléments de connexions forment par exemple un bloc monolithique avec lesdites surfaces conductrices.

La base comportant une surface conductrice extérieure formant masse, une surface conductrice de ladite paroi latérale est par exemple reliée électriquement à la dite surface formant masse.

Un ou plusieurs éléments de connexion extérieurs sont par exemple reliés chacun électriquement à l'intérieur de ladite cavité par un trou métallisé, ledit trou métallisé étant relié électriquement par une extrémité à l'élément de connexion extérieur et par une autre extrémité à une surface conductrice intérieure de ladite base.

Ladite base comporte par exemple une surface conductrice intérieure formant plage d'accueil dudit au moins composant et apte à être reliée électriquement à sa masse, ladite surface intérieure étant reliée électriquement à la surface extérieure de ladite base par au moins un trou métallisé traversant le matériau isolant de ladite base, les entrées et sorties de signaux dudit composant étant connectés à une surface intérieure de ladite base reliée électriquement aux éléments de connexions extérieurs.

Dans un autre mode de réalisation possible, ladite base comporte une partie sans matériau isolant de façon à permettre le montage dudit au moins composant directement sur la surface conductrice extérieure.

Au moins une autre paroi latérale est par exemple composée d'un matériau isolant recouvert d'au moins une couche conductrice.

Au moins une autre paroi comporte par exemple au moins une plage d'accueil apte au montage d'au moins un composant, les entrées et sorties dudit composant étant reliées électriquement à une surface conductrice intérieure de ladite base, elle-même reliée électriquement aux éléments de connexions extérieurs.

Dans un autre mode de réalisation possible, les autres parois latérales sont entièrement métalliques.

Le capot est par exemple composé d'un matériau isolant recouvert d'au moins une couche conductrice.

Le capot comporte par exemple au moins une plage d'accueil apte au montage d'au moins un composant, les entrées et sorties dudit composant étant reliées électriquement à une surface conductrice intérieure de ladite base, elle-même reliée électriquement aux éléments de connexions extérieurs.

Dans un autre mode de réalisation possible, le capot est entièrement métallique.

L'invention concerne également pour objet un montage comprenant un boîtier tel que décrit précédemment et un circuit multicouche comportant au moins un plan de masse et des pistes conductrices, au moins un trou métallisé étant réalisé dans ledit circuit en regard d'un élément de connexion extérieur dudit boîtier relié électriquement à la masse dudit au moins composant, les éléments de connexions extérieurs étant reliés auxdites pistes conductrices, ledit boîtier étant monté de telle façon que le plan de ladite base dudit boîtier soit perpendiculaire au plan dudit circuit.

D'autres caractéristiques et avantages de l'invention apparaîtront à l'aide de la description qui suit, faite en regard de dessins annexés qui représentent :
- La figure 1, un exemple de boîtier hyperfréquence selon l'art antérieur ;
- Les figures 2a et 2b, une illustration du principe de réalisation d'un boîtier selon l'invention ;
- La figure 3, un exemple de réalisation d'un boîtier selon l'invention ;
- Les figures 4, 5 et 6, d'autres exemples de réalisation possible d'un boîtier selon l'invention.

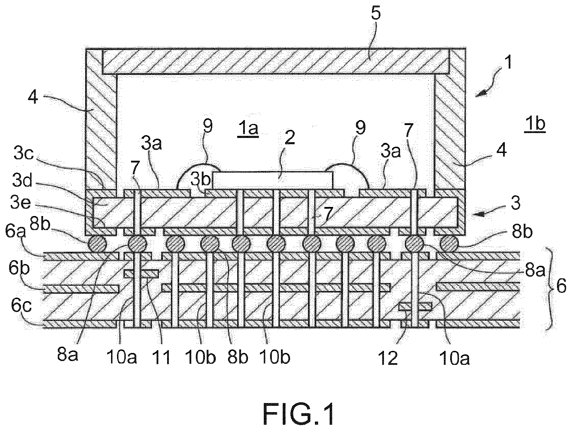

La figure 1 rappelle une solution de boîtier hyperfréquence, de type BGA, selon l'art antérieur, par une vue en coupe. Le boîtier 1 permet de délimiter un volume intérieur 1a. Une base 3 forme le fond du boîtier. La base est destinée à être montée sur un circuit extérieur 6, par exemple du type multicouche. La base 3 peut être un circuit imprimé comprenant deux couches conductrices. Bien entendu, le circuit imprimé formant la base peut comprendre un nombre différent de couches conductrices. Le circuit formant la base 3 peut être réalisé en utilisant un matériau isolant, de préférence organique. Ce matériau isolant peut être métallisé par du cuivre par exemple pour former les deux couches conductrices. En d'autres termes, le circuit comprend une épaisseur de matériau isolant 3d, sur laquelle sont déposées des couches conductrices de part et d'autre de l'épaisseur isolante.
La première couche conductrice forme une face intérieure du boîtier 1. Cette couche comprend des surfaces conductrices 3a, 3b, 3c gravées par des procédés connus de l'homme du métier.

Dans cet exemple la seconde couche conductrice peut former une face extérieure du boîtier. Elle comprend essentiellement une surface conductrice unique 3e. Cette surface conductrice 3e recouvre presque entièrement toute la surface de la base 3 en formant une masse. Cette masse est destinée à être reliée électriquement au circuit extérieur 6.
Le boîtier comporte en outre une structure conductrice 4, 5 qui forme avec la surface 3e, une cage de Faraday entourant le volume intérieur 1a du boîtier. Le volume intérieur 1a est ainsi protégé contre les perturbations électromagnétiques extérieures. La structure conductrice peut être formée par un capot métallisé. La structure conductrice est par exemple formée par des murs métalliques 4 recouverts par une plaque métallique 5. La plaque métallique 5, les murs 4, et la base 3 peuvent être brasés.
A titre d'exemple, on présente un composant hyperfréquence 2 monté dans le boîtier 1, un tel boîtier pouvant contenir un circuit avec plusieurs composants. La masse du composant est en contact avec une surface conductrice 3b de la couche intérieure de la base 3. Le composant hyperfréquence peut être une puce nue par exemple. Cette puce peut être brasée ou collée avec une colle conductrice, sur la surface conductrice 3b. La surface conductrice 3b est reliée électriquement à la couche extérieure 3e par un ou plusieurs, de préférence plusieurs, trous métallisés 7. On réalise ainsi une masse hyperfréquence. Les trous métallisés 7 sont bouchés pour assurer l'étanchéité du boîtier 1.
Les entrées et sorties hyperfréquence et basse fréquence de la puce 2 sont reliées à des pistes 3a de la couche intérieure de la base 3, par exemple avec des fils conducteurs 9. Chaque piste 3a est par exemple reliée électriquement à un disque, non représenté, de la couche extérieure de la base 3. Cette liaison électrique est réalisée par des trous métallisés de signal 7, traversant la base 3, acheminant respectivement les signaux hyperfréquence et les signaux basse fréquence, les trous métallisés 7 étant bouchés pour assurer l'étanchéité du boîtier 1.
Des billes conductrices 8a sont placés en contact avec les trous métallisés 7, directement ou par l'intermédiaire des disques non représentés. Ces billes conductrices 8a font partie intégrante du boîtier. Elles forment alors les points de connexion du boîtier. Les billes conductrices 8a peuvent être des billes d'étain-plomb par exemple. Elles présentent l'avantage de ne pas se déformer lors du montage du boîtier sur le circuit extérieur 6, ce qui permet de maîtriser la distance entre le boîtier 1 et le circuit 6. Les billes 8a peuvent être brasées ou collées, de préférence brasées, sur le circuit 6.
La couche conductrice intérieure peut comprendre une surface conductrice 3c. La surface conductrice 3c est reliée électriquement avec la couche conductrice extérieure 3e par des trous métallisés, de préférence bouchés. Ces trous métallisés sont par exemple répartis selon un maillage régulier. Les pistes conductrices 3a destinées à transmettre des signaux hyperfréquence sont par exemple placées dans des évidements de la surface conductrice 3c, de sorte à blinder ces pistes dans le plan de ces pistes (couche intérieure).
Des trous métallisés de masse, non représentés relient électriquement la surface conductrice intérieure 3c avec la couche conductrice extérieure 3e, ces trous étant par exemple bouchés pour assurer l'étanchéité du boîtier 1. Ils sont répartis en périphérie des trous métallisés de signaux hyperfréquence 7. De cette manière, un blindage hyperfréquence est réalisé dans l'épaisseur de la base 3, c'est à dire dans l'épaisseur isolante 3d. Avantageusement, ces trous métallisés sont au moins au nombre de trois par trou métallisé de signal hyperfréquence 7. Ils sont de préférence répartis sur 360° de manière à former un blindage complet.
Des billes conductrices de masse, non représentées, sont par exemple placées à la sortie des trous métallisés de masse. Ces billes conductrices font partie intégrante du boîtier 1. De cette manière, on forme une structure coaxiale qui blinde les connexions entre l'entrée-sortie hyperfréquence et le circuit 6. En d'autres termes, on réalise un blindage au niveau de la connexion elle-même, c'est à dire dans l'espace compris entre le boîtier et le circuit 6.
D'autres billes conductrices 8b, faisant partie intégrante du boîtier 1, peuvent être placées pour relier électriquement la surface conductrice 3e avec la masse du circuit 6. Ces billes conductrices 8b ne sont pas nécessairement dans le prolongement des trous métallisés formés dans la base 3.
Le diamètre des billes (de masse et de signal hyperfréquence ou basse fréquence), le diamètre des trous métallisés, la distance entre une bille de signal et les billes de masse l'entourant, et le nombre de billes de masse, sont par exemple déterminés pour obtenir une impédance contrôlée, par exemple de 50 Ohm.

La figure 1 présente un exemple de circuit sur lequel peut être monté le boîtier 1. Dans cet exemple, le circuit 6 est un circuit multicouche. Ce circuit 6 comprend au moins un plan de masse conducteur 6a. Un trou métallisé 10a est réalisé dans le circuit multicouche en regard de point de connexion 8a du boîtier 1, de sorte à acheminer le signal à travers le plan de masse conducteur 6a. Le signal arrive par l'intermédiaire du trou métallisé 10a à une piste 11 par exemple, la piste et le plan de masse formant une structure permettant de faire propager un signal hyperfréquence. Le circuit comprend un second plan de masse conducteur 6b placé sous la piste 11. En d'autres termes, le circuit 6 comprend deux couches de masse hyperfréquence 6a, 6b entre lesquelles se propage un signal hyperfréquence. On forme ainsi une structure blindée.
Une partie du signal étant acheminée entre les plans de masse 6a et 6b, on réalise par exemple au moins une connexion avec une autre couche du circuit 6 placée sous le plan de masse 6b. On peut ainsi propager des signaux hyperfréquences dans des couches différentes 11, 12 du circuit 6. Un troisième plan de masse 6c est par exemple placé sous la couche 12. Bien entendu, le circuit multicouche 6 peut avoir une configuration différente. Il peut comporter davantage de plans de masse et davantage de couches propageant des signaux hyperfréquence ou basse fréquence.
Les billes de masse du boîtier sont par exemple reliées au plan de masse 6a. Elles peuvent aussi être reliées aux autres plans de masses par des trous métallisés. Les plans de masses conducteurs du circuit sont par exemple reliés entre eux par des trous métallisés 10b. On forme ainsi un blindage hyperfréquence dans l'épaisseur du circuit.
Le boîtier illustré en figure 1 présente de très bonnes performances, notamment électromagnétiques et de tenue aux contraintes mécaniques et environnementales. Cependant, il est encombrant en surface. Il possède en effet une surface importante puisqu'il doit comprendre les composants, leur interconnexion intermédiaire et ses parois.
Cet encombrement en surface peut être problématique. C'est le cas notamment où la surface disponible pour recevoir les composants encapsulés est contrainte, comme par exemple dans les modules d'émission et de réception de type actif, où la maille est liée à la longueur d'onde des signaux émis.
Une solution connue pour diminuer la surface occupée sur le circuit imprimé est de réaliser la fonction hyperfréquence encapsulée dans le boîtier sur plusieurs étages. Cependant cette solution est complexe à mettre en oeuvre.

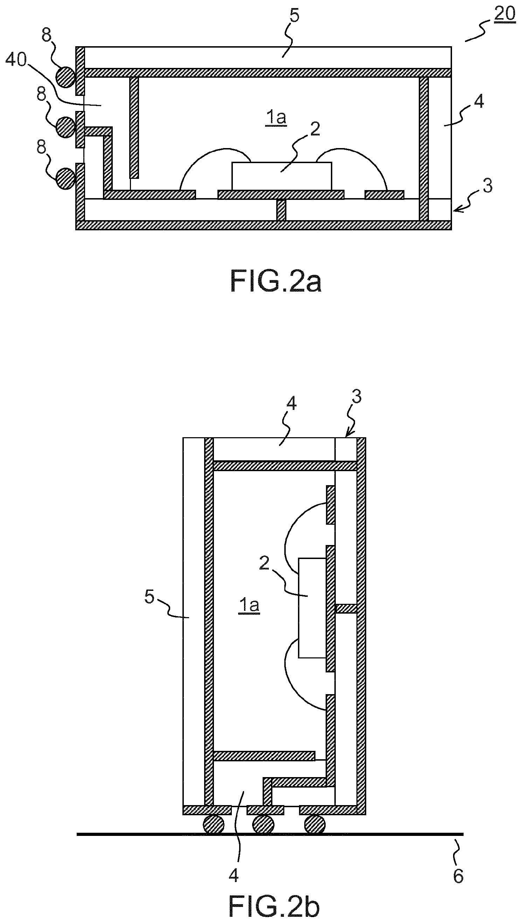

Les figures 2a et 2b illustrent le principe de réalisation d'un boîtier hyperfréquence selon l'invention. Le boîtier 20 forme une cavité 1a reposant sur une base 3 sur laquelle viennent s'interconnecter du côté intérieur le ou les composants 2 à encapsuler, la base étant entourée de parois latérales 4, dont l'une au moins 40 contient des connexions électriques 8 reliées d'une part vers l'intérieur de la cavité à la base 3, et d'autre part vers l'extérieur de la cavité à des points de connexion externes, les parois étant refermées du côté opposé à base par un capot 5.
La structure de la base 3, du capot 5 et des parois 4, à l'exception de la paroi 40 équipée des connexions électriques 8, sont par exemple les mêmes que celles du boîtier décrit par la figure 1. Comme dans le cas de la figure 1, l'exemple de boîtier qui est décrit par la suite comprend un seul composant hyperfréquence 2 sur la base.
Un boîtier selon l'invention est donc un boîtier dont l'interconnexion est assurée par des connexions, par exemple des billes métalliques 8, placées sur l'une des parois, donc dans un plan perpendiculaire à la surface des composants 2. De cette façon, le boîtier est reporté perpendiculairement à la surface du circuit imprimé 6 comme l'illustre la figure 2b. Ainsi, la surface prise par le boîtier sur le circuit imprimé est celle d'une des parois, et n'est plus contrainte par la surface des composants et de leur connexion intermédiaire. A titre d'exemple, pour un boîtier ayant une longueur L et une largeur l de l'ordre de 6 mm et une hauteur h de l'ordre de 1mm, la surface servant à l'implantation sur le circuit imprimé est donc L x l = 6 mm², au lieu de L x l = 36 mm². Cette solution est notamment adaptée pour les boîtiers comportant un faible nombre de billes, et donc des fonctions simples comme on peut en rencontrer dans le domaine hyperfréquence.

Un autre avantage de l'invention est qu'elle permet d'assurer plus facilement un bon contact thermique avec un radiateur en plaçant celui-ci contre la base 3 du boîtier.

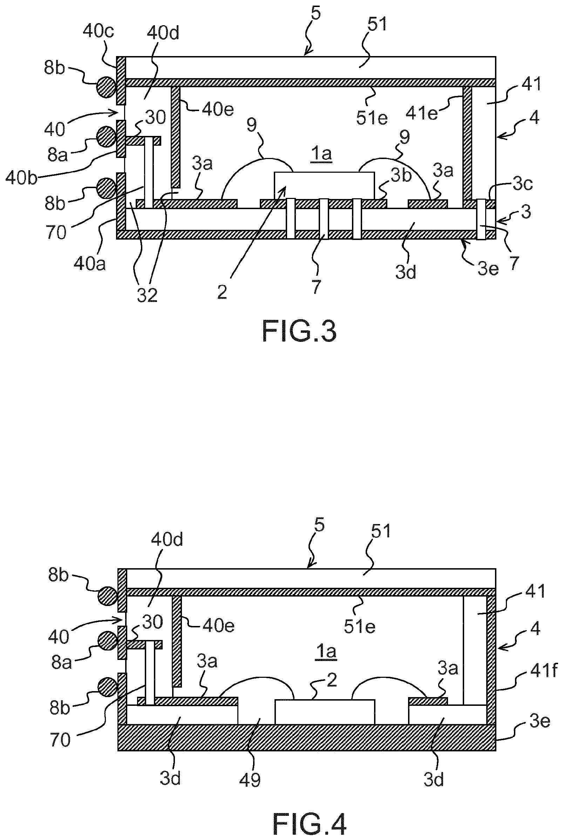

La figure 3 présente un premier mode de réalisation possible d'un boîtier selon l'invention. Dans cet exemple, la base 3 supportant le composant 2 est un circuit imprimé comportant une épaisseur de matériau isolant 3d sur laquelle sont déposées de part et d'autre des couches conductrices. La couche conductrice intérieure comprend plusieurs surfaces conductrices 3a, 3b, 3c. La couche conductrice extérieure comprend essentiellement une surface conductrice unique 3e. Cette surface conductrice recouvre entièrement, ou presque, toute la surface de la base 3 en formant une masse, cette masse étant destinée à être reliée électriquement au circuit extérieur 6, par exemple un circuit imprimé du type de celui présenté en figure 1. A cet effet, cette couche conductrice est prolongée par une surface conductrice 40a recouvrant une partie externe de la paroi 40 équipée des connexions électriques. Les connexions électriques sont par exemple des billes 8a, 8b. Au moins une bille 8b est fixée sur cette surface conductrice pariétale 40a, par brasage ou par collage par exemple. La liaison électrique de la couche de masse 3e avec le circuit 6 se fait donc par l'intermédiaire de la surface conductrice pariétale 40a et de la bille métallique 8b. Une seule bille 8b est représentée sur la figure 3. En pratique, une ou plusieurs rangées de billes métalliques peuvent être utilisées, en fonction de la fonction hyperfréquence encapsulée et de la place disponible. Les billes conductrices font par exemple partie intégrante de la paroi 40, plus particulièrement forment un bloc monolithique avec les surfaces conductrices 40a, 40b, 40c de la paroi.
Le boîtier comporte une structure conductrice qui forme avec la surface de masse 3e de la base une cage de Faraday entourant le volume intérieur 1a du boîtier. Cette structure conductrice est formée de la paroi 40 équipée des connexions électriques 8a, 8b, des autres parois 4 et d'un capot 5. Des modes de réalisation du capot 5 et des autres parois seront décrits par la suite. On continue la description de la paroi 40 équipée des connexions électriques en relation avec son interconnexion au composant 2.

Cette paroi 40 est composée d'un matériau isolant 40d, diélectrique, recouvert de part et d'autre d'une couche conductrice. Une couche conductrice interne 40e complète la structure conductrice formant une cage de Faraday. Du côté extérieur, la paroi 40 comporte une couche conductrice composée de plusieurs surfaces. Une première surface 40a prolongeant la couche de masse 3e de la base a déjà été décrite. Une autre surface 40c est reliée électriquement au capot 5. Elle comporte par exemple au moins une bille métallique 8b permettant de relier électriquement le capot au circuit externe 6, en particulier au potentiel de masse comme pour la couche 3e de la base. Une seule bille 8b est représentée sur la figure 3, en pratique cette surface 40c comporte plusieurs billes réparties en une ou plusieurs rangées comme l'autre surface 40a. Pour décrire une troisième couche 40b, on revient à la connexion du composant hyperfréquence 2.
La masse du composant est en contact avec une surface 3b de la première couche de la base 3, cette surface 3b formant plage d'accueil du composant. Ce composant peut être une puce nue, brasée ou collée. Cette surface 3b est elle-même reliée à la couche de masse 3e de la base par un ou plusieurs trous métallisés 7, permettant ainsi de relier la masse du composant au potentiel de masse du circuit externe 6 via la surface conductrice 40a prolongeant la couche de masse 3b.
Les entrées et sorties hyperfréquence et basse fréquence du composant 2 sont reliées à des pistes conductrices 3a de la couche intérieure de la base 3, par exemple par des fils conducteurs. Les pistes conductrices 3a sont reliées à des billes métalliques pariétales 8a par l'intermédiaire de trous métallisés 70 réalisés à l'intérieur du matériau isolant 40d de la paroi 40, ces trous métallisés reliant électriquement les pistes 3a aux billes métalliques pariétales 8a. A cet effet, les pistes conductrices 3a se prolongent sous la paroi 40, plus particulièrement sous le diélectrique 40d. Un espace minimum 32 est prévu pour éviter tout contact électrique des pistes conductrices 3a avec les autres couches internes 40e ou externe 40 a.
De même, un élément conducteur 30, relié électriquement à une surface pariétale 40b, pénètre le diélectrique. Au moins un trou métallisé 70 relie électriquement cet élément conducteur 30 à la piste conductrice 3a. La surface pariétale 40b reliée ainsi électriquement à la piste conductrice 3a comporte une ou plusieurs billes métalliques 8a. L'ensemble des connexions au circuit externe 6 se fait au travers de ces billes pariétales 8a, 8b véhiculant soit les signaux hyperfréquence, soit les signaux basse fréquence, soit le potentiel de masse.
Dans l'exemple de réalisation de la figure 3, les autres parois 4 sont également formées d'un matériau isolant 41 recouvert d'une couche interne conductrice 41e. Le capot 5 est également formé d'un matériau isolant 51 recouvert d'une couche conductrice 51e. Les couches conductrices 41e sont par exemple reliées à une surface conductrice 3c de la couche interne de la base, cette surface conductrice 3c étant reliée à la couche de masse de la base par un trou métallisé 7. Des blindages du type de ceux réalisés dans le boîtier de la figure 1 sont par exemple réalisés pour le boîtier selon l'invention tel que décrit par la figure 3.
Les parties isolantes 3d, 40d, 41, 51 du boîtier sont par exemple réalisées avec un substrat ayant une constante diélectrique contrôlée et une tangente de perte faible, par exemple à base de céramique, de téflon ou d'hydrocarbure chargé en fibre de verre ou en poudre de silice. Les couches conductrices peuvent être réalisées avec du cuivre. Les billes conductrices peuvent être réalisées avec un alliage à base d'étain.

La figure 4 présente une variante de réalisation où le composant 2 à encapsuler est placé directement sur une surface métallique 3e, conductrice, afin de faciliter la dissipation thermique. Cette surface métallique est la surface conductrice extérieure 3e de l'embase. Dans ce cas, l'embase 3 comporte une partie 49 sans isolant pour permettre le montage du composant directement sur la surface métallique 3e. L'épaisseur de cette surface métallique 3e est suffisante pour assurer la tenue mécanique de l'ensemble du boîtier. La couche conductrice 41f recouvrant les matériaux isolant 41 des parois 4 est par exemple placée du côté extérieur.

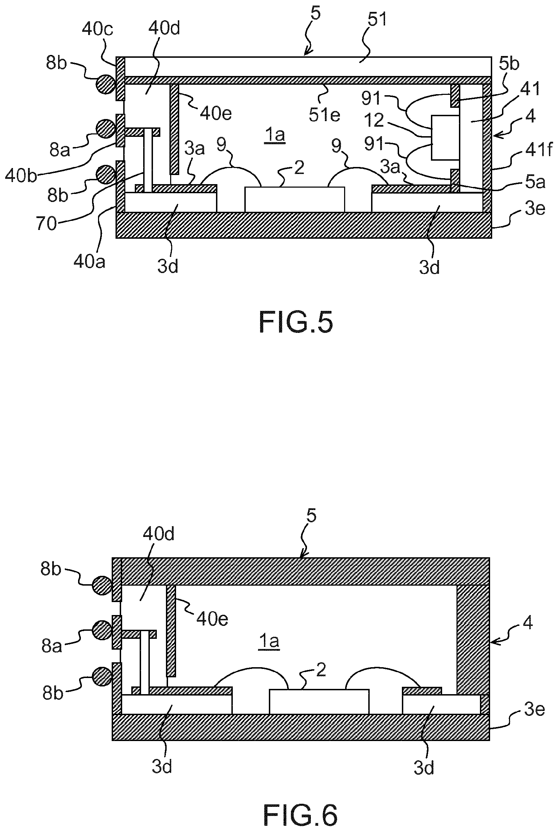

La figure 5 présente une autre variante de réalisation où les parois elles-mêmes comportent une ou plusieurs plages d'accueil de composants. Dans l'exemple de réalisation de la figure 5, une paroi 4 porte un composant 12. La paroi 4 est par exemple constituée comme dans l'exemple de la figure 4. Dans l'exemple de la figure 5, le composant 12 est placé sur l'isolant 41 de la paroi 4, ses entrées et sorties de signaux hyperfréquence et de signaux basse fréquence étant reliés par des fils d'interconnexion 91 à une piste 5a placée sur l'isolant 41 de la paroi 4 et étant relié électriquement à la piste 3a de l'embase, elle-même relié électriquement à des billes 8a comme décrit précédemment. D'autres fils d'interconnexion 91 relient la masse du composant à une piste de masse 5b elle-même reliée électriquement aux autres surfaces de masse.
En réalisant le capot 5 avec la même structure que la paroi 4, on peut de même prévoir des plages d'accueil pour monter des composants sur le capot, comme pour les parois. Les composants, qui sont par exemple des puces nues, peuvent être fixés par collage ou brasage. La masse électrique du ou des composants peut être reliée au potentiel de masse par une surface conductrice extérieure 4c de la paroi 40 reliée électriquement à la couche métallique du capot. Les entrées et sorties des signaux hyperfréquence et basse fréquence du composant peuvent être reliées électriquement à des éléments de connexions extérieures via des pistes ou surfaces conductrices 5a, 5b des parois latérales 4.

La figure 6 présente une autre variante de réalisation possible où les parois 4 qui ne sont pas équipées des billes métalliques d'interconnexion 8a, 8b sont entièrement métalliques. De même, le capot 5 peut être entièrement métallique.

## Revendications

1. Boîtier, apte à encapsuler au moins un composant hyperfréquence (2), formant une cavité fermée de type cage de Faraday ayant des parois latérales (4, 40) reposant sur une base (3) surmontées d'un capot (5), **caractérisé en ce qu'**au moins une (40) desdites parois latérales comporte des éléments de connexions électriques extérieurs (8, 8a, 8b) reliées électriquement à l'intérieur de ladite cavité, lesdits éléments de connexions extérieures (8, 8a, 8b) étant aptes à s'interconnecter avec un circuit extérieur (6) de sorte que ladite paroi latérale (40) soit face audit circuit extérieur (6) lorsque lesdits éléments de connexions extérieures sont interconnectées avec ledit circuit.

2. Boîtier selon la revendication 1, **caractérisé en ce que** lesdites connexions extérieures (8, 8a, 8b) sont des billes conductrices.

3. Boîtier selon l'une quelconque des revendications précédentes, **caractérisé en ce que** ladite paroi latérale (40) est composée d'un matériau isolant (40d) recouvert côté extérieur d'une couche comprenant plusieurs surfaces conductrices (40a, 40b, 40c) isolées électriquement les unes des autres et recouvert côté intérieur d'une surface conductrice unique (40e), lesdits éléments de connexions extérieures (8a, 8b) étant fixées sur lesdites surfaces conductrices (40a, 40b, 40c).

4. Boîtier selon les revendications 1 et 2, **caractérisé en ce que** lesdits éléments de connexions (8a, 8b) forment un bloc monolithique avec lesdites surfaces conductrices (40a, 40b, 40c).

5. Boîtier selon l'une quelconque des revendications 3 ou 4, **caractérisé en ce que** la base (3) comportant une surface conductrice extérieure (3e) formant masse, une surface conductrice (40a) de ladite paroi latérale (40) est reliée électriquement à la dite surface formant masse.

6. Boîtier selon l'une quelconque des revendications précédentes, **caractérisé en ce qu'**un ou plusieurs éléments de connexion extérieurs (8a) sont reliés chacun électriquement à l'intérieur de ladite cavité par un trou métallisé (70), ledit trou métallisé étant relié électriquement par une extrémité à l'élément de connexion extérieur (8a) et par une autre extrémité à une surface conductrice intérieure (3a) de ladite base (3).

7. Boîtier selon l'une quelconque des revendications 5 ou 6, **caractérisé en ce que** ladite base (3) comporte une surface conductrice intérieure (3b) formant plage d'accueil dudit au moins composant (2) et apte à être reliée électriquement à sa masse, ladite surface intérieure (3b) étant reliée électriquement à la surface extérieure (3e) de ladite base par au moins un trou métallisé (7) traversant le matériau isolant (3d) de ladite base, les entrées et sorties de signaux dudit composant étant connectés à une surface intérieure (3a) de ladite base reliée électriquement aux éléments de connexions extérieurs (8a).

8. Boîtier selon l'une quelconque des revendications 5 ou 6, **caractérisé en ce que** ladite base (3) comporte une partie (49) sans matériau isolant de façon à permettre le montage dudit au moins composant (2) directement sur la surface conductrice extérieure (3e).

9. Boîtier selon l'une quelconque des revendications précédentes, caractérisé en qu'au moins une autre paroi latérale (4) est composée d'un matériau isolant (41) recouvert d'au moins une couche conductrice (41e).

10. Boîtier selon l'une quelconque des revendications précédentes, **caractérisé en ce qu'**au moins une autre paroi (4) comporte au moins une plage d'accueil apte au montage d'au moins un composant (12), les entrées et sorties dudit composant (12) étant reliées électriquement à une surface conductrice intérieure (3a) de ladite base, elle-même reliée électriquement aux éléments de connexions extérieurs.

11. Boîtier selon l'une quelconque des revendications 1 à 8, **caractérisé en ce que** les autres parois latérale (4) sont entièrement métalliques.

12. Boîtier selon l'une quelconque des revendications précédentes, caractérisé en que le capot (5) est composé d'un matériau isolant (51) recouvert d'au moins une couche conductrice (51e).

13. Boîtier selon l'une quelconque des revendications précédentes, **caractérisé en ce que** le capot (5) comporte au moins une plage d'accueil apte au montage d'au moins un composant (12), les entrées et sorties dudit composant (12) étant reliées électriquement à une surface conductrice intérieure (3a) de ladite base, elle-même reliée électriquement aux éléments de connexions extérieurs.

14. Boîtier selon l'une quelconque des revendications 1 à 11, **caractérisé en ce que** le capot est entièrement métallique.

15. Montage comprenant un boîtier (20) selon l'une quelconque des revendications précédentes et un circuit multicouche (6) comportant au moins un plan de masse et des pistes conductrices, au moins un trou métallisé étant réalisé dans ledit circuit en regard d'un élément de connexion extérieur dudit boîtier relié électriquement à la masse dudit au moins composant (2, 12), les éléments de connexions extérieurs étant reliés auxdites pistes conductrices, ledit boîtier étant monté de telle façon que le plan de ladite base (3) dudit boîtier soit perpendiculaire au plan dudit circuit (6).

## Patentansprüche

1. Gehäuse, das wenigstens eine Mikrowellenkomponente (2) verkapseln kann, das einen geschlossenen Hohlraum des Faraday-Käfigtyps mit lateralen Wänden (4, 40) bildet, die auf einer Basis (3) ruhen, auf der eine Kappe (5) sitzt, **dadurch gekennzeichnet, dass** wenigstens eine (40) der lateralen Wände externe elektrische Verbindungselemente (8, 8a, 8b) umfasst, die elektrisch mit der Innenseite des Hohlraums verbunden sind, wobei die externen Verbindungselemente (8, 8a, 8b) mit einer externen Schaltung (6) verbunden werden können, so dass die laterale Wand (40) der externen Schaltung (6) gegenüberliegt, wenn die externen Verbindungselemente mit der Schaltung verbunden sind.

2. Gehäuse nach Anspruch 1, **dadurch gekennzeichnet, dass** die externen Verbindungen (8, 8a, 8b) leitende Kugeln sind.

3. Gehäuse nach einem der vorherigen Ansprüche, **dadurch gekennzeichnet, dass** die laterale Wand (40) von einem Isoliermaterial (40) gebildet wird, das auf der Außenseite mit einer Schicht bedeckt ist, die mehrere leitende Flächen (40a, 40b, 40c) umfasst, die elektrisch voneinander isoliert sind und auf der Innenseite mit einer einzelnen leitenden Fläche (40e) bedeckt ist, wobei die externen Verbindungselemente (8a, 8b) auf den leitenden Flächen (40a, 40b, 40c) fixiert sind.

4. Gehäuse nach den Ansprüchen 1 und 2, **dadurch gekennzeichnet, dass** die Verbindungselemente (8a, 8b) einen monolithischen Block mit den leitenden Flächen (40a, 40b, 40c) bilden.

5. Gehäuse nach einem der Ansprüche 3 oder 4, **dadurch gekennzeichnet, dass** die Basis (3) eine Masse bildende externe leitende Fläche (3e) umfasst, und eine leitende Fläche (40a) der lateralen Wand (40) elektrisch mit der Masse bildenden Fläche verbunden ist.

6. Gehäuse nach einem der vorherigen Ansprüche, **dadurch gekennzeichnet, dass** eine oder mehrere externe Verbindungselemente (8a) jeweils elektrisch mit der Innenseite des Hohlraums über ein metallisiertes Loch (70) verbunden ist/sind, wobei das metallisierte Loch elektrisch an einem Ende mit dem externen Verbindungselement (8a) und an einem anderen Ende mit einer internen leitenden Fläche (3a) der Basis (3) verbunden ist.

7. Gehäuse nach einem der Ansprüche 5 oder 6, **dadurch gekennzeichnet, dass** die Basis (3) eine interne leitende Fläche (3b) umfasst, die einen Aufnahmebereich für die wenigstens eine Komponente (2) bildet und elektrisch mit ihrer Masse verbunden werden kann, wobei die interne Fläche (3b) elektrisch mit der Außenfläche (3e) der Basis durch wenigstens ein metallisiertes Loch (7) verbunden ist, das durch das Isoliermaterial (3d) der Basis passiert, wobei die Eingänge und Ausgänge von Signalen der Komponente mit einer Innenfläche (3a) der Basis verbunden sind, die elektrisch mit den externen Verbindungselementen (8a) verbunden ist.

8. Gehäuse nach Anspruch 5 oder 6, **dadurch gekennzeichnet, dass** die Basis (3) einen Teil (49) ohne Isoliermaterial umfasst, um die Montage der wenigstens einen Komponente (2) direkt an der externen leitenden Fläche (3e) zuzulassen.

9. Gehäuse nach einem der vorherigen Ansprüche, **dadurch gekennzeichnet, dass** wenigstens eine andere laterale Wand (4) durch ein Isoliermaterial (41) ausgebildet ist, das mit wenigstens einer leitenden Schicht (41e) bedeckt ist.

10. Gehäuse nach einem der vorherigen Ansprüche, **dadurch gekennzeichnet, dass** wenigstens eine andere Wand (4) wenigstens einen Aufnahmebereich für die Montage von wenigstens einer Komponente (12) umfasst, wobei die Eingänge und Ausgänge der Komponente (12) elektrisch mit einer internen leitenden Fläche (3a) der Basis verbunden ist, welche Basis elektrisch mit den äußeren Verbindungselementen verbunden ist.

11. Gehäuse nach einem der Ansprüche 1 bis 8, **dadurch gekennzeichnet, dass** die anderen lateralen Wände (4) gänzlich aus Metall gefertigt sind.

12. Gehäuse nach einem der vorherigen Ansprüche, **dadurch gekennzeichnet, dass** die Kappe (5) aus einem Isoliermaterial (51) gebildet ist, das von wenigstens einer leitenden Schicht (51e) bedeckt ist.

13. Gehäuse nach einem der vorherigen Ansprüche, **dadurch gekennzeichnet, dass** die Kappe (5) wenigstens einen Aufnahmebereich für die Montage wenigstens einer Komponente (12), aufweist, wobei die Eingänge und Ausgänge der Komponente (2) elektrisch mit einer internen leitenden Fläche (3a) der Basis verbunden sind, welche Basis elektrisch mit den externen Verbindungselementen verbunden ist.

14. Gehäuse nach einem der Ansprüche 1 bis 11, **dadurch gekennzeichnet, dass** die Kappe gänzlich aus Metall gefertigt ist.

15. Baugruppe, die ein Gehäuse (20) nach einem der vorherigen Ansprüche und eine mehrschichtige Schaltung (6) umfasst, die wenigstens eine Masseebene und Leiterbahnen umfasst, wobei wenigstens ein metallisiertes Loch in der Schaltung gegenüber einem externen Verbindungselement des Gehäuses vorgesehen ist, das mit der Masse der wenigstens einen Komponente (2, 12) elektrisch verbunden ist, wobei die externen Verbindungselemente mit den Leiterbahnen verbunden sind, wobei das Gehäuse so montiert ist, dass die Ebene der Basis (3) des Gehäuses lotrecht zur Ebene der Schaltung (6) ist.

## Claims

1. A casing, able to encapsulate at least one microwave component (2), forming a closed cavity of the Faraday cage type having lateral walls (4, 40) resting on a base (3) superposed by a cap (5), **characterised in that** at least one (40) of said lateral walls comprises external electrical connection elements (8, 8a, 8b) electrically connected to the inside of said cavity, said external connection elements (8, 8a, 8b) being capable of being interconnected with an external circuit (6) so that said lateral wall (40) is opposite said external circuit (6) when said external connection elements are interconnected with said circuit.

2. The casing as claimed in claim 1, **characterised in that** said external connections (8, 8a, 8b) are conductive beads.

3. The casing as claimed in any one of the preceding claims, **characterised in that** said lateral wall (40) is formed by an insulating material (40d) covered, on the external side, with a layer comprising a plurality of conductive surfaces (40a, 40b, 40c) electrically insulated from each other and covered, on the internal side, with a single conductive surface (40e), said external connection elements (8a, 8b) being fixed on said conductive surfaces (40a, 40b, 40c).

4. The casing as claimed in claims 1 and 2, **characterised in that** said connection elements (8a, 8b) form a monolithic block with said conductive surfaces (40a, 40b, 40c).

5. The casing as claimed in any one of claims 3 or 4, **characterised in that** the base (3) comprises an external conductive surface (3e) forming ground, and a conductive surface (40a) of said lateral wall (40) is electrically connected to said surface forming ground.

6. The casing as claimed in any one of the preceding claims, **characterised in that** one or more external connection elements (8a) is/are each electrically connected to the inside of said cavity via a metallised hole (70), said metallised hole being electrically connected by one end to the external connection element (8a) and by another end to an internal conductive surface (3a) of said base (3).

7. The casing as claimed in any one of claims 5 or 6, **characterised in that** said base (3) comprises an internal conductive surface (3b) forming a reception section for said at least one component (2) and being capable of being electrically connected to its ground, said internal surface (3b) being electrically connected to the external surface (3e) of said base by at least one metallised hole (7) passing through the insulating material (3d) of said base, the inputs and outputs of signals of said component being connected to an internal surface (3a) of said base electrically connected to the external connection elements (8a).

8. The casing as claimed in any one of claims 5 or 6, **characterised in that** said base (3) comprises a portion (49) without insulating material so as to allow said at least one component (2) to be mounted directly on the external conductive surface (3e).

9. The casing as claimed in any one of the preceding claims, **characterised in that** at least one other lateral wall (4) is formed by an insulating material (41) covered with at least one conductive layer (41e).

10. The casing as claimed in any one of the preceding claims, **characterised in that** at least one other wall (4) comprises at least one reception sectiondesigned for assemblingat least one component (12), the inputs and outputs of said component (12) being electrically connected to an internal conductive surface (3a) of said base, which base is electrically connected to the external connection elements.

11. The casing as claimed in any one of claims 1 to 8, **characterised in that** the other lateral walls (4) are entirelymade of metal.

12. The casing as claimed in any one of the preceding claims, **characterised in that** the cap (5) is formed by an insulating material (51) covered by at least one conductive layer (51e).

13. The casing as claimed in any one of the preceding claims, **characterised in that** the cap (5) comprises at least one reception section designed for assembling at least one component (12), the inputs and outputs of said component (12) being electrically connected to an internal conductive surface (3a) of said base, which base is electrically connected to the external connection elements.

14. The casing as claimed in any one of claims 1 to 11, **characterised in that** the cap is entirely made of metal.

15. An assembly comprising a casing (20) as claimed in any one of the preceding claims and a multilayer circuit (6) comprising at least one ground plane and conductive tracks, at least one metallised hole being made in said circuit facing an external connection element of said casing electrically connected to the ground of said at least one component (2, 12), the external connection elements being connected to said conductive tracks, said casing being mounted such that the plane of said base (3) of said casing is perpendicular to the plane of said circuit (6).
